# EUROPEAN PATENT APPLICATION

(11) **EP 4 675 924 A2**
(43) Date of publication of application: **07.01.2026**
(21) Application number: 24797292.0
(22) Date of filing: 30.03.2024
(51) Int. Cl.: H03K 17/945, B66B 1/46

(54) **TOUCHLESS BUTTON SYSTEM**

(30) Priority: 27.04.2023 KR 20230055235
(71) Applicant: Ilion Co., Ltd., Goyang city Gyeonggi-do 10442 (KR); Shin, Kyong Min, Goyang city Gyeonggi-do 10442 (KR)
(72) Inventor: BYUN, Hoonsuk, Goyang city Gyeonggi-do 10417 (KR)
(74) Representative: De Vries & Metman
(86) International application number: PCT/KR2024/004122
(87) International publication number: WO 2024/225630

(57) **Abstract**

The present invention relates to a touchless button system. The present invention comprises a plurality of buttons, an end ToF sensor installed at a top or bottom of a line in which the plurality of buttons are arranged to face the plurality of buttons, and a control unit configured to select one button among the plurality of buttons using distance information of an object sensed by the ToF sensor. The touchless button system according to the present invention has the advantage of high object recognition accuracy while having low manufacturing cost.

## Description

### FIELD OF THE INVENTION

The present invention relates to a touchless button system, and more particularly, to a touchless button system equipped with distance sensors.

### BACKGROUND ART

Elevators are installed in high-rise buildings such as buildings or apartments to facilitate vertical movement. Users who board an elevator typically move to their destination floor or open and close the elevator doors by pressing elevator touch buttons with floor numbers displayed with their fingers.

Conventional elevator touch buttons are push-type or capacitive-type that detect changes in capacitance, but in any case, finger contact with the button is required. Recently, hygiene of public facilities has been considered an important issue, and methods to minimize contact with hands, which contain many contaminants, are being studied. Therefore, to reduce the spread of infectious diseases by elevator touch buttons installed in subway stations, airports, hospitals, etc., structures that can register destination floors by touchless methods and can be easily applied to already installed elevators are being proposed.

One method for implementing a touchless (or non-touch) button system with high sensing accuracy is to use distance sensors. However, the structure of applying distance sensors to each elevator button requires replacing all buttons, which increases the manufacturing cost of the button system. This increase in manufacturing cost is particularly serious when there are many elevator buttons, such as in high-rise buildings.

### DETAILD DESCRIPTION OF THE INVENTION

### TECHNICAL PROBLEM

Therefore, the present invention aims to provide a touchless button system equipped with ToF sensors that has high sensing accuracy while having low manufacturing cost.

### TECHNICAL SOLUTION

The present invention, for solving the above purpose, provides, as one feature, a touchless button system comprising: a plurality of buttons; an end distance sensor disposed at an end of a line in which the plurality of buttons are arranged, the end distance sensor facing the plurality of buttons; and a control unit configured to select one button among the plurality of buttons using distance information of an object detected by the distance sensor.

Preferably, the distance sensor has a sensing direction parallel to a surface on which the plurality of buttons are installed, and is installed in a form protruding outward from the button installation surface.

Preferably, the system further comprises a central distance sensor disposed at a middle portion of the button arrangement line to face an opposite side of the end distance sensor.

Preferably, the control unit is configured to ignore an approach of the object when the object approaches a button from a side of the button, and to process the approach of the object as a valid input when the object approaches the button from a front side of the button.

Preferably, the end distance sensor is a multi-zone sensor having a plurality of sensing areas disposed adjacent in a lateral direction, and the control unit is configured to process the approach of the object as a valid input only when the object sequentially passes through at least two of the plurality of sensing areas of the end distance sensor.

Preferably, the distance sensor is a time-of-flight (ToF) sensor.

### TECHNICAL EFFECTS

According to the present invention having the above-described configuration, the touchless button system equipped with distance sensors has advantages of high object recognition accuracy while having low manufacturing cost.

### BRIEF DESCRIPTION OF THE DRAWINGS

FIG. 1 illustrates the configuration and operation of a touchless button system according to an embodiment of the present invention.
FIG. 2 is a detailed configuration diagram of the distance measurement unit shown in FIG. 1.
FIG. 3 is a configuration diagram of the ToF (Time of Flight) sensor shown in FIG. 2.
FIG. 4 illustrates the configuration and operation of a touchless button system according to another embodiment of the present invention.
FIG. 5 illustrates the operation according to the movement direction of an object in the touchless button system shown in FIG. 4.
FIG. 6 illustrates the configuration and operation of a touchless button system according to another embodiment of the present invention.
FIG. 7 illustrates the configuration and operation of a touchless button system according to yet another embodiment of the present invention.

### BEST MODE FOR ACCOMPLISHING THE INVENTION

To fully understand the present invention, preferred embodiments of the present invention will be described with reference to the accompanying drawings. The embodiments of the present invention may be modified in various forms, and the scope of the present invention should not be construed as being limited to the embodiments described in detail below. The present embodiment is provided to more completely explain the present invention to those having ordinary knowledge in the art. Therefore, the shapes of elements in the drawings may be exaggerated to emphasize clearer description. It should be noted that the same members in each drawing may be shown with the same reference numerals. Detailed descriptions of known functions and configurations that may unnecessarily obscure the subject matter of the present invention are omitted.

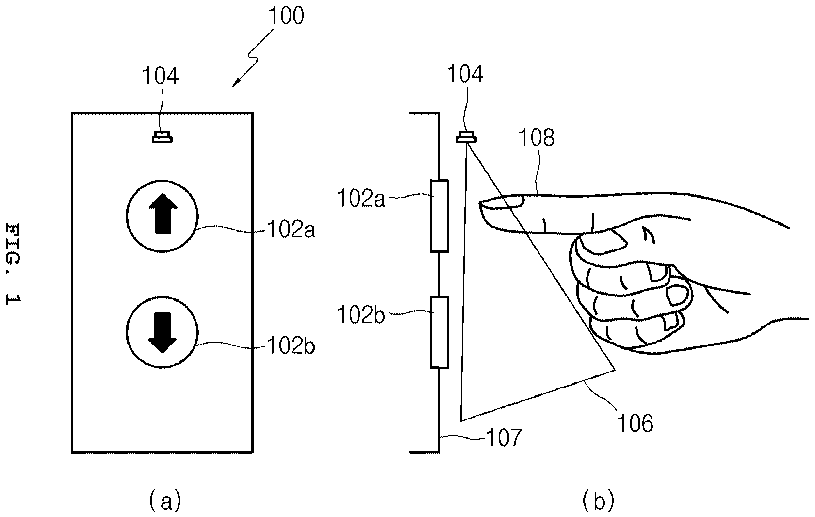

FIG. 1 is a diagram illustrating the configuration and operation of a touchless button system 100 according to an embodiment of the present invention, where FIG. 1(a) is a front view and FIG. 1(b) is a side view. As shown, the touchless button system 100 comprises a plurality of (two as an example) buttons 102a, 102b and a distance measurement unit 104. The distance measurement unit 104 comprises a ToF sensor as a distance sensor and a control unit for button selection, as described in detail below.

The ToF sensor is installed at an end of a line where the plurality of buttons 102a, 102b are arranged to face all of the plurality of buttons 102a, 102b. Since the plurality of buttons 102a, 102b are arranged in a vertical direction, the ToF sensor may be installed at the upper end or lower end along the vertical arrangement line. Also, the ToF sensor is installed to have a sensing area 106 in front of a surface 107 where the plurality of buttons 102 are installed. To facilitate implementing such a sensing area 106, the ToF sensor is installed in a form protruding externally from the button installation surface 107.

When an object 108 approaches to select a specific button of the touchless button system 100, the ToF sensor of the distance measurement unit 104 senses the distance to the object 108 and transmits information about the sensed distance to the control unit. The control unit operates so that one button 102a among the plurality of buttons 102a, 102b is selected from the distance information to the object 108 transmitted from the ToF sensor.

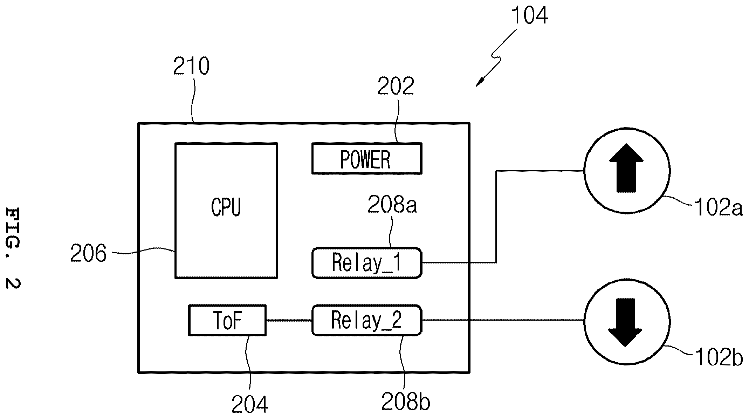

FIG. 2 is a detailed configuration diagram of the distance measurement unit 104 shown in FIG. 1. As shown, the distance measurement unit 104 comprises a power supply unit 202, control unit 204, ToF sensor 206, relays 208a, 208b, and circuit board 210.

The power supply unit 202 receives power from outside and converts it to power for driving the distance measurement unit 104. The ToF sensor 204 is a distance sensor that senses the distance to objects within the sensing area. The control unit 206 determines the selected button from the distance sensed by the ToF sensor 204, generates a control signal according to the determination result, and provides it to the selected relay. When a control signal is provided from the control unit 206, relay 208a causes button 102a to be selected, and relay 208b causes button 102b to be selected. The circuit board 210 provides electrical connections between the components 202, 204, 206, 208a, 208b.

The touchless button system 100 according to this embodiment is easy to install and has low installation cost since only the distance measurement unit 104 needs to be installed in an existing button system.

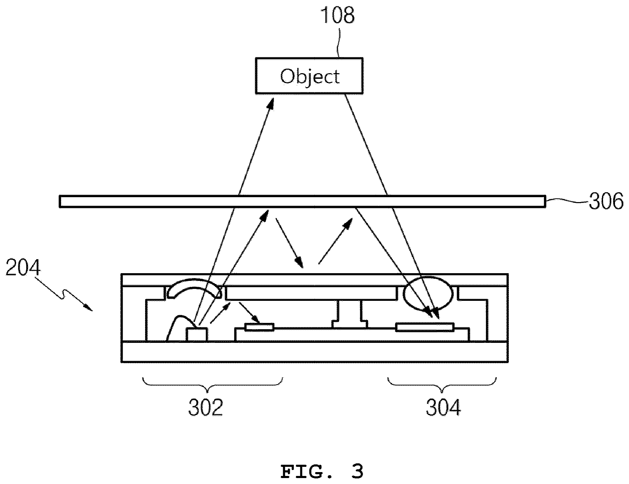

FIG. 3 is a configuration diagram of the ToF (Time of Flight) sensor shown in FIG. 2. As shown, the ToF sensor 204 comprises a transmitting unit 302 and receiving unit 304. For example, the transmitting unit consists of a VCSEL (Vertical Cavity Surface Emitting Laser), and the receiving unit consists of a SPAD (Single Photon Avalanche Diode). The distance measurement unit 104 may comprise a glass plate 306 etc. in front of the ToF sensor 204 to prevent contamination or damage of the ToF sensor 204.

The transmitting unit 302 transmits infrared light, and the receiving unit 304 receives reflected infrared light. For example, the FOI (Field of illumination) of the transmitting unit 302 is approximately 40 degrees, and the FOV (Field of View) of the receiving unit 304 is 30 to 60 degrees in the Y-axis direction and 30 to 42 degrees in the X-axis direction. The ToF sensor 204 measures the distance to the object 108 by measuring the time from when infrared light is transmitted from the transmitting unit 302 to when the signal reflected from the object 108 is received by the receiving unit 304.

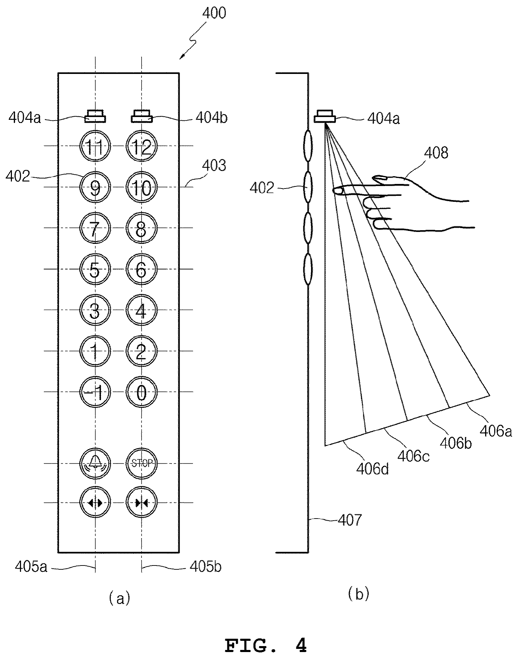

FIG. 4 is a diagram illustrating the configuration and operation of a touchless button system 400 according to another embodiment of the present invention, where FIG. 4(a) is a front view and FIG. 4(b) is a left side view. As shown, the touchless button system 400 comprises a plurality of buttons 402 and distance measurement units 404a, 404b. The distance measurement units 404a, 404b comprise ToF sensors as distance sensors and control units for button selection.

The plurality of buttons are arranged along 10 arrangement lines 403 in the horizontal direction and along 2 arrangement lines 405a, 405b in the vertical direction. The ToF sensor may be installed at the right end or left end along the horizontal arrangement line 403, and at the upper end or lower end along the vertical arrangement lines 405a, 405b to face buttons of the same arrangement line. In the touchless button system 400 shown in FIG. 4, since the number of vertical arrangement lines 405a, 405b is small, it is advantageous to install the distance measurement units 404a, 404b at the top or bottom of the vertical arrangement lines as this can reduce the number of ToF sensor installations. The distance measurement unit 404a is installed to face buttons arranged along the same arrangement line 405a, and the distance measurement unit 404b is installed to face buttons arranged along the same arrangement line 405b.

As distance sensors of the distance measurement units 404a, 404b, multi-zone ToF sensors having a plurality of sensing areas 406a, 406b, 406c, 406d adjacent in the lateral direction may be used. Multi-zone ToF sensors can recognize not only the distance to objects but also the sensing area where objects exist. The distance measurement units 404a, 404b are installed so that the ToF sensors have a plurality of sensing areas 406a, 406b, 406c, 406d sequentially according to distance in front of the surface 407 where the plurality of buttons 402 are installed. To facilitate implementing such sensing areas 406a, 406b, 406c, 406d, the distance measurement units 404a, 404b are installed in a form protruding externally from the button installation surface 407.

When an object 408 approaches to select a specific button of the touchless button system 400, the ToF sensors of the distance measurement units 404a, 404b sense the distance to the object 408 and transmit information about the sensed distance to the control unit. The control unit operates so that one button among the plurality of buttons 402 is selected from the distance information to the object 408 transmitted from the ToF sensors.

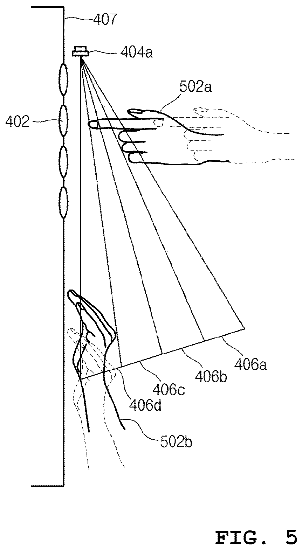

FIG. 5 illustrates the operation according to the movement direction of objects 502a, 502b in the touchless button system 400 shown in FIG. 4. Since object 502a normally approaches from the front of button 402 to select a specific button, the control unit of the distance measurement units 404a, 404b effectively processes the approach of such object 502a. For example, when a visually impaired person gropes with their hand to check Braille, when approaching the button 402 from the side of the button 402 like object 502b, the control unit ignores the approach of object 502b. Therefore, the touchless button system 400 causes a specific button to be selected only when object 502b touches the button, preventing malfunction for groping motions of visually impaired people. As shown in FIG. 5, when the distance measurement unit 404a comprises a multi-zone ToF sensor, the control unit effectively processes the approach of an object to cause a specific button to be selected only when the object sequentially passes through at least two of the plurality of sensing areas 406a, 406b, 406c, 406d of the ToF sensor.

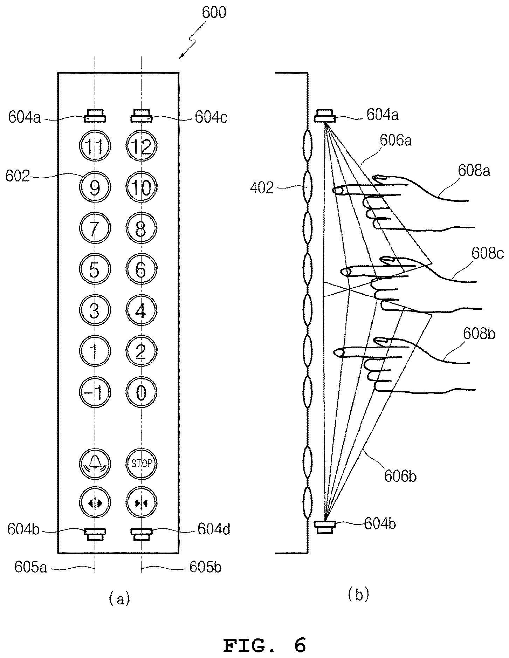

FIG. 6 is a diagram illustrating the configuration and operation of a touchless button system 600 according to another embodiment of the present invention, where FIG. 6(a) is a front view and FIG. 6(b) is a left side view. As shown, the touchless button system 600 comprises a plurality of buttons 602 and distance measurement units 604a, 604b, 604c, 604d. The distance measurement units 604a, 604b, 604c, 604d comprise ToF sensors as distance sensors and control units for button selection.

As shown in FIG. 6(b), when the number of buttons 602 arranged in arrangement lines 605a, 605b is large compared to the sensing area of the ToF sensor of the distance measurement unit, distance measurement units may be installed not only at the top but also at the bottom of the arrangement lines 605a, 605b. The distance measurement unit 604a installed at the top of arrangement line 605a to face downward buttons senses whether buttons arranged in the upper half of arrangement line 605a are selected. The distance measurement unit 604b installed at the bottom of arrangement line 605a to face upward buttons senses whether buttons arranged in the lower half of arrangement line 605a are selected. The distance measurement unit 604c installed at the top of arrangement line 605b to face downward buttons senses whether buttons arranged in the upper half of arrangement line 605b are selected. The distance measurement unit 604d installed at the bottom of arrangement line 605b to face upward buttons senses whether buttons arranged in the lower half of arrangement line 605b are selected.

In FIG. 6(b), object 608a is located only in sensing area 606a so it is sensed by distance measurement unit 604a, and object 608b is located only in sensing area 606b so it is sensed by distance measurement unit 604b. However, when located in multiple sensing areas 606a, 606b like object 608c, multiple distance measurement units 604a, 604b sense the approach of the object, so multiple buttons may be selected. In this case, malfunction can be prevented by controlling so that only the distance measurement unit that sensed a closer distance selects a button. To implement this, the distance measurement units 604a, 604b, 604c, 604d may be configured to share sensed distance information with each other.

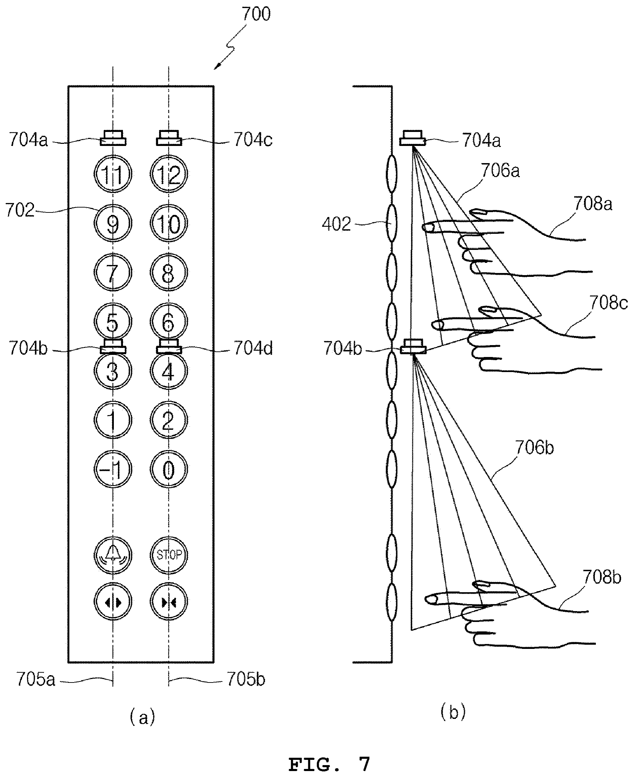

FIG. 7 is a diagram illustrating the configuration and operation of a touchless button system 700 according to yet another embodiment of the present invention, where FIG. 7(a) is a front view and FIG. 7(b) is a left side view. As shown, the touchless button system 700 comprises a plurality of buttons 702 and distance measurement units 704a, 704b, 704c, 704d. The distance measurement units 704a, 704b, 704c, 704d comprise ToF sensors as distance sensors and control units for button selection.

As shown in FIG. 7(b), when the number of buttons 702 arranged in arrangement lines 705a, 705b is large compared to the sensing area of the ToF sensor of the distance measurement unit, distance measurement units may be installed not only at the top (or bottom) but also at the center of the arrangement lines 705a, 705b. The distance measurement unit 704a installed at the top of arrangement line 705a to face downward buttons senses whether buttons arranged in the upper half of arrangement line 705a are selected. The distance measurement unit 704b installed at the center of arrangement line 705a to face downward buttons (i.e., to face the opposite direction of distance measurement unit 704a) senses whether buttons arranged in the lower half of arrangement line 705a are selected. The distance measurement unit 704c installed at the top of arrangement line 705b to face downward buttons senses whether buttons arranged in the upper half of arrangement line 705b are selected. The distance measurement unit 704d installed at the center of arrangement line 705b to face downward buttons (i.e., to face the opposite direction of distance measurement unit 704c) senses whether buttons arranged in the lower half of arrangement line 705b are selected.

In FIG. 7(b), object 708a is located only in sensing area 706a so it is sensed by distance measurement unit 704a, and object 708b is located only in sensing area 706b so it is sensed by distance measurement unit 704b. However, when located in multiple sensing areas 706a, 706b like object 708c, multiple distance measurement units 704a, 704b sense the approach of object 708c, so multiple buttons may be selected. In this case, malfunction can be prevented by controlling so that only the distance measurement unit that sensed a closer distance selects a button. To implement this, the distance measurement units 704a, 704b, 704c, 704d may be configured to share sensed distance information with each other.

Although not shown, overall power consumption can be reduced by having a separate sensor with a long recognition distance to determine the presence of objects and controlling the position recognition ToF sensor installed on the button to be in a low power state when the presence of objects is not detected.

The embodiments of the present invention described above are merely exemplary, and those having ordinary knowledge in the art to which the present invention belongs will be able to understand that various modifications and equivalent other embodiments are possible therefrom. Therefore, it will be well understood that the present invention is not limited only to the forms mentioned in the detailed description above. Therefore, the true technical protection scope of the present invention should be determined by the technical spirit of the appended claims. Also, the present invention should be understood to include all modifications, equivalents, and substitutes within the spirit and scope of the present invention defined by the appended claims.

## Claims

1. A touchless button system comprising:
a plurality of buttons;
an end distance sensor disposed at an end of a line in which the plurality of buttons are arranged, the end distance sensor facing the plurality of buttons; and
a control unit configured to select one button among the plurality of buttons using distance information of an object detected by the distance sensor.

2. The touchless button system of claim 1, wherein the distance sensor has a sensing direction parallel to a surface on which the plurality of buttons are installed.

3. The touchless button system of claim 2, wherein the distance sensor is installed in a form protruding outward from the button installation surface.

4. The touchless button system of claim 1, further comprising a central distance sensor disposed at a middle portion of the button arrangement line to face an opposite side of the end distance sensor.

5. The touchless button system of claim 1, wherein the end distance sensor is a multi-zone sensor having a plurality of sensing areas arranged adjacent to one another in a lateral direction.

6. The touchless button system of claim 5, wherein the control unit is configured to process an approach of the object as a valid input only when the object sequentially passes through at least two of the plurality of sensing areas of the end distance sensor.

7. The touchless button system of claim 1, wherein the distance sensor is a time-of-flight (ToF) sensor.
